**Europäisches Patentamt**

**European Patent Office**

**Office européen des brevets**

(11) Numéro de publication : **0 343 030 B1**

(12) **FASCICULE DE BREVET EUROPEEN**

(45) Date de publication du fascicule du brevet :
**12.08.92 Bulletin 92/33**

(51) Int. Cl.⁵ : **H05K 1/00,** G06K 19/06,
H01L 23/50

(21) Numéro de dépôt : **89401213.7**

(22) Date de dépôt : **28.04.89**

(54) **Circuit imprimé souple, notamment pour carte à microcircuits électroniques, et carte incorporant un tel circuit.**

(30) Priorité : **09.05.88 FR 8806201**

(43) Date de publication de la demande :
**23.11.89 Bulletin 89/47**

(45) Mention de la délivrance du brevet :
**12.08.92 Bulletin 92/33**

(84) Etats contractants désignés :
**AT BE CH DE ES FR GB IT LI NL SE**

(56) Documents cités :
**EP-A- 0 207 853**
**FR-A- 87 716**

(73) Titulaire : **BULL CP8**
**Rue Eugène Hénaff BP 45**
**F-78190 Trappes (FR)**

(72) Inventeur : **Champagne, Daniel**
**35, Rue des Peupliers**
**F-78790 Septeuil (FR)**
Inventeur : **Le Loc'H, Alain**
**16, Rue Montbauron**
**F-78000 Versailles (FR)**
Inventeur : **Lefort, Olivier**
**2, Rue Louise Damasse**
**F-27200 Vernon (FR)**

(74) Mandataire : **Siloret, Patrick et al**
**Bull S.A. Industrial Property Department P.C.:**
**HQ 8M006 B.P. 193.16 121,Avenue de Malakoff**
**F-75116 Paris (FR)**

**Description**

L'invention se rapporte à un circuit imprimé souple et convient plus particulièrement aux cartes à microcircuits électroniques dont l'épaisseur satisfait aux normes ISO (International Standard Organisation) des cartes de crédit, et à une carte incorporant un tel circuit.

Une carte à microcircuits électroniques est une plaquette rectangulaire monobloc ou multicouches en matériau plastique, qui incorpore des microcircuits électroniques et présente extérieurement des contacts pour la connexion des microcircuits électroniques avec un appareil de traitement de cartes. Ces microcircuits peuvent être destinés à des fonctions très diverses, telles que par exemple les opérations bancaires de débit et de crédit, l'allocation d'unités téléphoniques et l'entrée confidentielle dans un milieu protégé. Ils constituent généralement des circuits de traitement et/ou de mémoire plus ou moins complexes selon l'usage auquel ils sont destinés. Dans la pratique, ils sont formés sur au moins une plaquette de silicium appelée couramment circuit intégré, puce ou chip.

Un mode de réalisation d'une carte à microcircuits électroniques consiste à fixer dans une cavité de la carte un circuit imprimé portant le circuit intégré et les contacts de la carte. Le circuit imprimé est fait à partir d'une feuille mince en matériau souple tel que du polyester, du verre époxy, ou bien encore un matériau plastique présentant une souplesse suffisante. Etant donné que le circuit imprimé pourvu des contacts et du circuit intégré doit être incorporé dans une carte dont l'épaisseur normalisée est de 0,762 mm ± 10 %, la feuille du circuit imprimé doit être mince, de l'ordre de 130 micromètres par exemple. Le matériau souple de la feuille et sa minceur en font un élément compatible avec la souplesse requise par l'ISO pour les cartes du type cartes de crédit.

L'invention se rapporte plus particulièrement à un circuit imprimé souple, dont l'extrémité d'une face porte le circuit intégré et l'autre extrémité de l'autre face présente les contacts de la carte. Les contacts sont ainsi décalés relativement au circuit intégré et sont reliés aux plots du circuit intégré par des conducteurs respectifs formés sur une face de la feuille. Pour des raisons de commodité, on appelle face supérieure ou extérieure de la feuille ou du circuit imprimé la face par laquelle les contacts sont accessibles au niveau de la carte, l'autre face étant dite inférieure ou intérieure. Par ailleurs, on appelle axe du circuit, l'axe joignant les contacts de la carte et le circuit intégré.

Selon un mode de réalisation, les conducteurs et les contacts associés sont formés sur la face supérieure de la feuille. Le circuit intégré est soudé aux extrémités correspondantes des conducteurs disposés en porte à faux dans une ouverture ménagée dans la feuille. Ces extrémités de conducteurs forment souvent des plages facilitant leur connexion aux plots correspondants du circuit intégré. L'avantage de ce circuit imprimé est d'être mince, du fait que l'épaisseur du circuit intégré ne s'ajoute pas à l'épaisseur de la feuille.

Selon un autre mode de réalisation, c'est la face du circuit intégré opposée à celle portant les plots qui est fixée à la face inférieure de la feuille, et les plots du circuit intégré sont alors reliés aux extrémités correspondantes des conducteurs de la feuille par des fils conducteurs. Cette technique est appelée "Wire Bonding".

Cependant, dans ces divers modes de réalisation la disposition extérieure des conducteurs du circuit exige parfois l'emploi d'une pellicule de protection recouvrant seulement le circuit imprimé, mais plus avantageusement étalée sur toute la face de la carte, notamment quand les conducteurs du circuit imprimé risquent de se trouver à proximité ou au contact d'une piste magnétique. Il est alors impossible de déposer la piste magnétique si elle n'est pas supportée par un matériau homogène. Bien entendu, dans ce cas la pellicule est pourvue d'ouvertures pour donner accès aux contacts. Une variante de réalisation consiste à former les conducteurs sur la face inférieure de la feuille. Le circuit intégré est soudé sur les extrémités correspondantes des conducteurs, tandis qu'à l'autre extrémité, les contacts sont accessibles au travers d'ouvertures ménagées dans la feuille. Cette variante ne nécessite pas l'emploi d'une pellicule mais elle a l'inconvénient d'ajouter les épaisseurs de la feuille et du circuit intégré.

Le décalage des contacts relativement au circuit intégré peut être préféré pour plusieurs raisons, notamment celle visant à satisfaire des normes d'emplacement des contacts sur la grande médiane de la carte, au voisinage d'un petit côté. Grâce à cette disposition, le circuit intégré peut demeurer dans un coin de la carte où les contraintes à la flexion et à la torsion sont nettement plus faibles qu'au niveau des contacts. Les normes ISO édictent également que les contacts doivent être au nombre de six ou huit, répartis de manière égale sur deux rangées parallèles à un petit côté de la carte. Selon une autre disposition de l'ISO, les contacts doivent avoir une surface minimale prédéterminée, de forme rectangulaire. Les conducteurs partent ordinairement des contacts et rejoignent de façon évidemment la plus directe et la plus compacte les plots respectifs du circuit intégré. Pour satisfaire aux normes internationales, la carte doit pouvoir subir sans dommage un nombre donné de flexions, faites suivant l'une et l'autre des deux médianes de la carte. Des exigences plus draconiennes peuvent être définies contractuellement. Dans ces conditions, il s'avère que les circuits imprimés à contacts décalés conçus de manière classique satisfont déjà mal aux normes minimales. En règle générale, les flexions qui se répercutent dans le sens de l'axe du circuit sont les plus dommageables. Les dommages se caractérisent par des coupures au niveau des conducteurs. Des études ont donc été entreprises pour rechercher la meilleure métallurgie et le meilleur mode de fabrication des conducteurs. Les résultats obtenus se sont avérés insatisfaisants autant sur le plan qualité que sur le plan fiabilité.

L'invention procure à un circuit imprimé souple les moyens pour assurer durablement la qualité des liaisons électriques entre les contacts et les plots du circuit, en dépit des contraintes exercées par la flexion du circuit imprimé.

Elle est tout particulièrement adaptée à l'implantation qui vient d'être décrite, dans laquelle les contacts sont près de la grande médiane de la carte, à proximité d'un petit côté, et dans laquelle simultanément le circuit est près d'un coin de la carte, mais elle s'applique également à des implantations différentes, notamment dans le cas où les contacts seraient encore près de la grande médiane et d'un petit côté de la carte, alors que le circuit intégré serait plus près du centre de la carte, sur la grande médiane ; d'une façon plus générale, elle s'applique à toutes les implantations possibles dans lesquelles l'axe du circuit est parallèle à l'un des côtés de la carte (grand ou petit) et dans laquelle l'implantation des contacts avec l'extérieur satisfait ou non aux normes édictées dans ce domaine, ou bien encore d'autres implantations dans lesquelles l'axe du circuit n'est plus parallèle à l'un ou l'autre des côtés de la carte.

Selon l'invention, un circuit imprimé souple pourvu de conducteurs connectés à des contacts répartis dans une première zone et destinés à une connexion faite dans une seconde zone éloignée de la première, lesdits conducteurs partant des contacts respectifs sensiblement perpendiculairement à l'axe du circuit imprimé joignant les deux zones, est caractérisé en ce que lesdits conducteurs forment par la suite des boucles ou sinuosités relativement à cet axe, jusqu'à la seconde zone.

Cette structure permet de réduire au minimum les tronçons de conducteurs en ligne droite disposés parallèlement au dit axe de la feuille du circuit imprimé, de sorte que lorsque le circuit subit des flexions, les sinuosités confèrent une certaine liberté aux conducteurs qui évite leur étirement. Dans le pire des cas, une flexion trop exagérée entrainerait éventuellement le décollement de l'un des tronçons de conducteurs entre les contacts et la zone de connexion, mais une coupure n'apparaîtrait pas, de sorte que la continuité électrique serait assurée. Un circuit imprimé souple selon le préambule de la revendication 1 est connu du document EP-A-0 207 853.

D'autres caractéristiques et avantages de l'invention ressortiront de la description qui suit, donnée à titre d'exemple et faite en référence aux dessins annexés, sur lesquels :

– la figure 1 est une vue de dessus d'une première variante de réalisation d'un circuit imprimé souple conforme à l'invention ;

– la figure 2 est une vue en coupe suivant la ligne II-II du circuit imprimé souple représenté sur la figure 1 et monté dans une carte du type carte de crédit illustrée partiellement ;

– la figure 3 est une vue de dessus de la carte globale représentée sur la figure 2 ;

– la figure 4 est une vue du dessus d'une seconde variante de réalisation d'un circuit imprimé souple conforme à l'invention ;

– la figure 5 est une vue de dessus d'un mode de réalisation d'une carte incorporant le circuit représenté sur la figure 4.

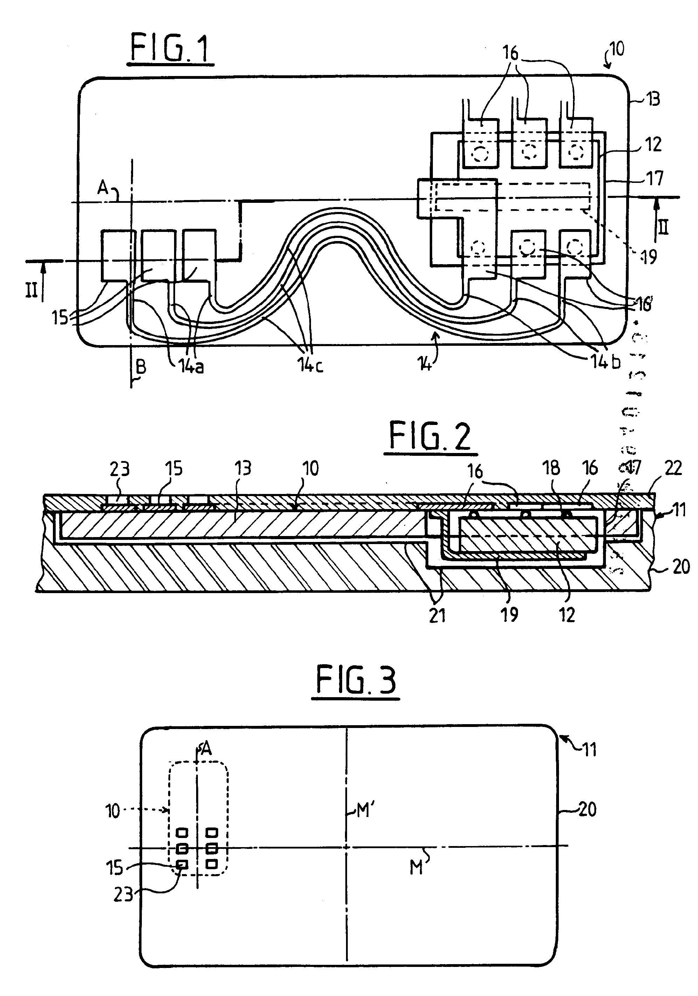

Les figures 1 à 3 illustrent un circuit imprimé souple 10 conforme à l'invention, destiné à une carte 11 du type carte de crédit normalisée et constituant une carte à microcircuits électroniques.

Comme l'illustre la figure 1, les microcircuits électroniques sont contenus dans un circuit intégré 12 fixé au circuit imprimé 10. De manière classique, le circuit imprimé 10 est fait à partir d'une feuille 13 rectangulaire, mince et souple, en matériau plastique généralement. Dans l'exemple, la face supérieure de la feuille 13 porte six conducteurs 14, dont trois seulement sont totalement représentés par souci de clarté, reliant respectivement six contacts 15 à six plages 16 de contact disposées en porte à faux autour d'une ouverture 17 ménagée dans la feuille 13. L'ouverture 17 contient le circuit intégré 12, dont les plots 18 sont soudés aux plages respectives 16. Dans l'exemple, l'axe A, qui relie la zone avec les contacts 15 à la zone avec les plages 16, est confondu avec la grande médiane de la feuille, de sorte que l'axe A du circuit est ici la grande médiane. Par ailleurs, chaque zone est à proximité de l'une des extrémités de ladite médiane.

Dans l'exemple illustré par la figure 2, les plots 18 sont directement soudés aux plages 16 de contact du circuit imprimé. Dans une variante non représentée, on utilise la technique décrite dans le préambule de la présente demande, selon laquelle la face du circuit intégré opposée à celle portant les plots 18 est un regard des plages 16 de contact, et dans laquelle les plots 18 sont alors reliés aux plages 16 par des fils conducteurs.

Dans le mode de réalisation illustré, le circuit intégré 12 est supposé du type MOS (Metal Oxyde Semiconductor), et une patte de polarisation 19 est alors fixée au dos du circuit intégré et connectée à une extension d'une plage 16 en général représentative de la masse. L'ouverture 17 est placée à une extrémité de la feuille rectangulaire 13 et est partagée par l'axe A du circuit. Les contacts 15 sont placés dans une région éloignée de l'ouverture 17 et placée sur l'axe A à l'autre extrémité de la feuille 13. Les contacts 15 sont disposés en deux rangées parallèles et, de préférence, équidistantes de part et d'autre de l'axe A. Il en est de même pour les plages 16. Les contacts 15 et les plages 16 illustrés ont une forme rectangulaire, dont les largeurs sont parallèles à cet axe. Les conducteurs qui relient les contacts 15 aux plages 16 sont minces et étroits par rapport à la largeur des contacts satisfaisant aux normes ISO. Par exemple, les conducteurs peuvent avoir une largeur de l'ordre de 300 micromètres.

Un exemple de fabrication d'une carte à microcircuits électroniques 11 incorporant le circuit imprimé 10 représenté sur la figure 1 est illustré dans les figures 2 et 3. La carte 11 est faite d'une plaquette 20 en matériau souple, dont les dimensions satisfont aux normes ISO. La plaquette 20 est de forme rectangulaire, de grande médiane M et de petite médiane M'. Elle peut être monobloc comme illustré, ou multicouche. Une face de la plaquette 20 présente une cavité 21 adaptée pour loger le circuit imprimé 10 pourvu du circuit intégré 12 de façon que la face supérieure du circuit imprimé 10 soit sensiblement coplanaire avec la face correspondante de la plaquette 20. L'ensemble de cette face est ensuite recouvert d'une pellicule 22 pourvue d'ouvertures 23 au niveau des contacts 15 pour leur connexion à un dispositif de traitement extérieur. Comme représenté sur la figure 3, on tire ordinairement avantage du circuit imprimé 10 en le plaçant dans la carte 11 de façon que l'axe A soit parallèle à un petit côté de la carte et que les contacts 15 soient placés au voisinage de ce côté, dans sa zone médiane. Dans l'exemple illustré, les contacts 15 accessibles par les ouvertures 23 sont répartis de part et d'autre de la grande médiane M de la carte.

Le circuit imprimé 10 et la carte 11 qui viennent d'être décrits sont classiques. L'invention consiste dans le fait que les conducteurs 14 partent des contacts respectifs 15 perpendiculairement à l'axe A du circuit imprimé 10 et forment par la suite des boucles ou sinuosités relativement à l'axe A. Plus précisément, chaque conducteur 14 se compose d'une partie 14a adjacente au contact respectif 15 et dirigée dans une direction B sensiblement perpendiculaire à l'axe A. De l'autre côté, chaque conducteur 14 aboutit en une partie 14b à la plage correspondante 16 dans une direction elle aussi sensiblement perpendiculaire à l'axe A. Dans la partie intermédiaire 14c, chaque conducteur présente au moins une boucle ou sinuosité relativement à l'axe A. On entend par boucle ou sinuosité une forme non linéaire ne présentant aucun angle sur le tracé de chaque conducteur.

En fait, on supprime au maximum les tronçons en ligne droite parallèles à l'axe du circuit imprimé reliant la zone où se trouvent les contacts 15, et la zone où se trouvent les plages de connexion avec les plots 18 du circuit intégré, et on rallonge ainsi la longueur des conducteurs par rapport à un tracé direct des contacts 15 aux plages 16, ce qui permet de compenser l'étirement qui apparaît lors des flexions, et évite leur cassure. Par ailleurs, des angles sur le tracé des conducteurs se comporteraient comme autant de points privilégiés de rupture lors des flexions qui entraîneraient une déformation au niveau des angles. C'est pourquoi, l'allongement du tracé des conducteurs est obtenu en réalisant des boucles ou sinuosités qui, elles, ne comportent pas de tels points privilégiés de rupture.

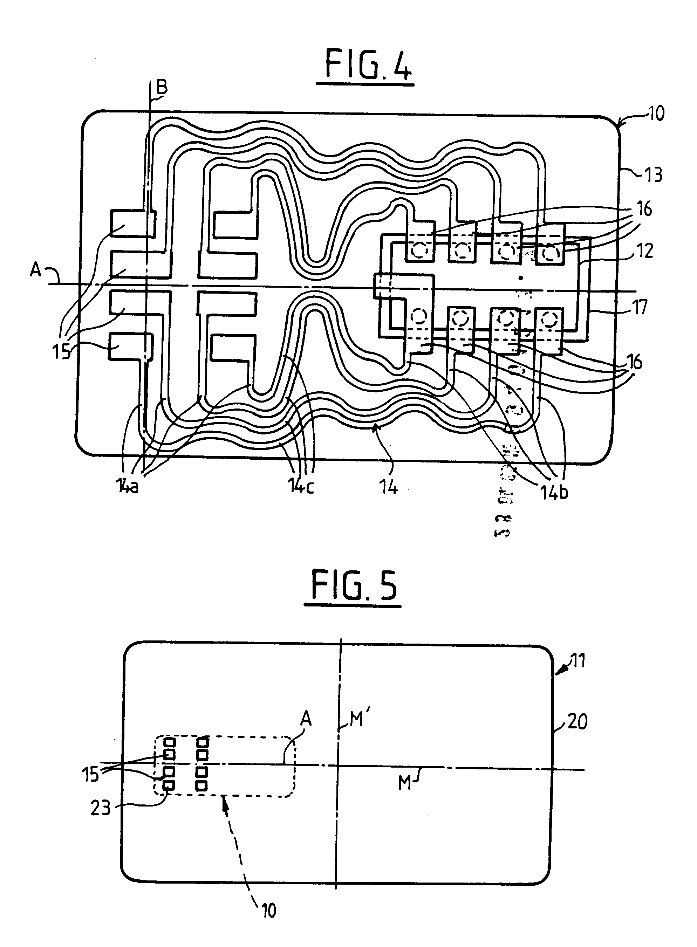

La figure 4 illustre une variante du circuit imprimé, dans laquelle les contacts 15 sont disposés en deux rangées perpendiculaires à l'axe A, dans une première zone de la feuille mince, et les plages 16 de connexion sont situées dans une seconde zone éloignée de la première, également à proximité de l'axe A ; par ailleurs, cette fois-ci, c'est la longueur des contacts 15 qui est parallèle à l'axe A de la feuille.

Cette variante permet, par exemple, de conserver la norme d'implantation des contacts 15 par rapport à la carte, c'est-à-dire en disposant les rangées parallèlement à l'un des petits côtés de la carte, mais en rapprochant cette fois-ci le circuit intégré du centre de la carte. Une telle implantation pourrait être envisagée à l'avenir pour une raison technique particulière.

Afin de permettre que tous les conducteurs 14 partent des contacts 15 sensiblement perpendiculairement à l'axe A, les contacts situés le plus à l'intérieur d'une rangée ont leur dimension parallèle à l'axe A supérieure à celle des contacts les plus à l'extérieur, de sorte que les contacts les plus à l'intérieur sont en débordement par rapport aux contacts les plus à l'extérieur et de ce fait sont accessibles perpendiculairement à l'axe par les tronçons 14a de conducteurs.

Une carte 11 incorporant un tel circuit imprimé 10 aurait, vue de dessus, l'aspect illustré par la figure 5. Dans ce cas, l'axe A du circuit imprimé 10 serait confondu avec la grande médiane M de la carte 11, les contacts 15 satisferaient aux normes actuelles. La plaquette 20 en matériau souple constituant le corps de la carte 11 pourrait avoir les mêmes caractéristiques de structure que celles illustrées par la figure 3. Notamment, elle pourrait être recouverte d'une pellicule 22 pourvue d'ouvertures 23 au niveau des contacts 15 pour leur connexion à un dispositif de traitement extérieur.

Dans l'exemple illustré par la figure 5, l'axe A du circuit imprimé est confondu avec la grande médiane M de la carte, de sorte que la puce est près du centre de la carte également sur la grande médiane. Il est bien entendu possible d'employer la variante illustrée par la figure 4 dans tous les cas où il serait nécessaire de placer pour une raison quelconque par exemple les contacts près d'un coin de la carte, en respectant la disposition dictée par les normes actuelles, et la puce simultanément près d'un grand côté, et d'une petite médiane M' de la carte.

Mais il est bien entendu que les illustrations qui ont été données ne sont absolument pas limitatives, et en particulier, un changement de normes dans la disposition des contacts imposant que les rangées ne soient plus parallèles à un petit côté de la carte, mais à un grand côté entrainerait par exemple que la seconde variante soit utilisée pour placer les contacts sur la grande médiane et la puce dans un coin, ou bien encore que la première variante décrite serait utilisé pour positionner les contacts 15 près d'une extrémité de la grande médiane M de la carte et le circuit intégré à proximité du centre de la carte

En outre, il est important de noter que la disposition soit des largeurs, soit des longueurs des contacts 15, parallèlement à l'axe A, telle qu'elle a été évoquée respectivement en regard des figures 1 ou 4, n'amène rien à l'invention et n'est pas nécessaire. Elle permet simplement de respecter les normes actuelles d'implantation des contacts 15 dans la carte dès lors que le circuit imprimé y est placé conformément aux modes de réalisation illustrés par les figures 3 ou 5 respectivement. Il en est de même de la forme rectangulaire des contacts 15 qui n'est pas nécessaire.

L'invention permet d'éviter au maximum que des tronçons de conducteurs en ligne droite soient parallèles à l'axe A du circuit imprimé 10.

Les avantages de l'invention sont les suivants. Selon les normes ISO ou par convention une carte à microcircuits électroniques doit subir sans dommage un nombre prédéterminé de flexions faites suivant la grande médiane M de la carte et le même nombre de flexions autour de la petite médiane M′. L'expérience révèle que les flexions de la carte 11 qui se répercutent sur l'axe A du circuit imprimé sont vite dommageables lorsque le circuit imprimé 10 est réalisé de façon classique. Des cassures se forment au niveau des conducteurs du circuit imprimé, qui rendent impossible ou erroné tout traitement de la carte. Un grand nombre d'essais ont été effectués en variant la conformation et la métallurgie des conducteurs. La disposition conforme à l'invention assure de façon optimale la fiabilité de la connexion électrique établie par les conducteurs 14 dans une carte 11 lorsqu'elle subit un grand nombre de flexions autour de ses deux médianes M, M′, qui se répercutent sur l'axe A du circuit imprimé.

## Revendications

1. Circuit imprimé souple (10) pourvu de conducteurs (14) connectés à des contacts (15) répartis dans une première zone du circuit et destinés à une connexion faite dans une seconde zone du circuit éloignée de la première, lesdits conducteurs (14) partant des contacts respectifs (15) sensiblement perpendiculairement à l'axe (A) du circuit imprimé joignant les deux zones, caractérisé en ce que lesdits conducteurs forment par la suite des boucles ou sinuosités relativement à cet axe, jusqu'à la seconde zone.

2. Circuit imprimé selon la revendication 1, caractérisé en ce que les contacts (15) sont répartis dans la première zone en deux rangées parallèles à l'axe (A) du circuit imprimé.

3. Circuit imprimé selon la revendication 1, caractérisé en ce que les contacts (15) sont répartis en deux rangées parallèles entre elles et perpendiculaires à l'axe (A) du circuit, et en ce que les contacts les plus à l'intérieur de la zone de contacts ont leur dimension parallèle au dit axe (A) supérieure à la dimension correspondante des contacts les plus à l'extérieur, de sorte que chaque contact (15) est accessible par un tronçon (14a) de conducteur aboutissant dans la première zone perpendiculairement à l'axe (A).

4. Circuit imprimé selon l'une des revendications 1 à 3, caractérisé en ce que les contacts (15) sont répartis dans la première zone uniformément de part et d'autre de l'axe (A) du circuit imprimé.

5. Circuit imprimé selon l'une des revendications 1 à 4, caractérisé en ce que les conducteurs aboutissent sensiblement perpendiculairement à l'axe (A) du circuit imprimé sur des plages (16) situées dans ladite seconde zone.

6. Circuit imprimé selon la revendication 5, caractérisé en ce que les plages (16) sont réparties dans la seconde zone uniformément de part et d'autre de l'axe A du circuit imprimé.

7. Circuit imprimé selon l'une des revendications 5 ou 6, caractérisé en ce qu'il porte, dans ladite seconde zone, un circuit intégré (12) pourvu de plots (18) connectés chacun à l'une des plages (16).

8. Circuit imprimé selon la revendication 7, caractérisé en ce que le circuit intégré est placé dans une ouverture (17) réalisée dans ladite seconde zone.

9. Carte à microcircuits électroniques (11), caractérisée en ce qu'elle incorpore un circuit imprimé tel que défini par l'une des revendications 1 à 8.

10. Carte selon la revendication 9, caractérisée en ce que l'axe (A) est parallèle à une médiane (M′) de la carte et les contacts (15) sont situés au voisinage de l'autre médiane (M) de la carte.

11. Carte selon la revendication 9, caractérisée en ce que l'axe (A) est parallèle à un petit côté de la carte et à la petite médiane (M′), et en ce que les contacts (15) sont situés au voisinage de la grande médiane (M) de la carte, près de l'une de ses extrémités.

12. Carte selon la revendication 9, caractérisée en ce que l'axe (A) est confondu avec la grande médiane (M) de la carte et en ce que les contacts (15) sont à proximité de l'une des extrémités de ladite médiane.

## Patentansprüche

1. Biegsame gedruckte Schaltung (10), die mit Leitern (14) versehen ist, welche mit in einer ersten Schaltungszone verteilten Kontakten (15) verbunden sind und für eine Verbindung in einer zweiten, von der ersten entfernten Schaltungszone bestimmt sind, wobei die genannten Leiter (14) die jeweiligen Kontakte (15) im wesentlichen senkrecht zur Achse (A) der gedruckten Schaltung, die an die beiden Zonen anstößt, verlassen, dadurch gekennzeichnet, daß die genannten Leiter in der Folge relativ zu dieser Achse bis zur zweiten Zone Schleifen oder Bögen bilden.

2. Gedruckte Schaltung gemäß Anspruch 1, dadurch gekennzeichnet, daß die Kontakte (15) in der ersten Zone in zwei parallelen Reihen zur Achse (A) der gedruckten Schaltung verteilt sind.

3. Gedruckte Schaltung gemäß Anspruch 1, dadurch gekennzeichnet, daß die Kontakte in zwei zueinander parallelen und zur Achse (A) der Schaltung senkrechten Reihen verteilt sind und daß die weiter innen liegenden Kontakte der Kontaktezone ihre Abmessung parallel zu dieser Achse (A) größer ausgebildet haben als die entsprechende Abmessung der weiter außen liegenden Kontakte ist, derart, daß jeder Kontakt (15) über ein in der ersten Zone senkrecht zur Achse (A) angrenzendes Leiterstück (14a) erreichbar ist.

4. Gedruckte Schaltung gemäß einem der Ansprüche 1 bis 3, dadurch gekennzeichnet, daß die Kontakte (15) in der ersten Zone gleichartig beiderseits der Achse (A) der gedruckten Schaltung verteilt sind.

5. Gedruckte Schaltung gemäß einer Ansprüche 1 bis 4, dadurch gekennzeichnet, daß die Leiter im wesentlichen senkrecht zur Achse (A) der gedruckten Schaltung an die in der genannten zweiten Zone gelegenen Bereiche (16) angrenzen.

6. Gedruckte Schaltung gemäß Anspruch 5, dadurch gekennzeichnet, daß die Bereiche (16) in der zweiten Zone gleichartig beiderseits der Achse (A) der gedruckten Schaltung verteilt sind.

7. Gedruckte Schaltung gemäß einem der Ansprüche 5 oder 6, dadurch gekennzeichnet, daß sie in der genannten zweiten Zone einen integrierten Schaltkreis (12) trägt, der mit Blöcken (18) versehen ist, von denen jeder mit einem der Bereiche (16) verbunden ist.

8. Gedruckte Schaltung gemäß Anspruch 7, dadurch gekennzeichnet, daß der integrierte Schaltkreis in einer in der genannten zweiten Zone ausgebildeten Öffnung angeordnet ist.

9. Karte mit elektronischer Mikroschaltung (11), dadurch gekennzeichnet, daß sie eine gedruckte Schaltung enthält, wie sie durch einen der Ansprüche 1 bis 8 definiert ist.

10. Karte gemäß Anspruch 9, dadurch gekennzeichnet, daß die Achse (A) paralllel zu einer Mittellinie (M') der Karte ist und die Kontakte (15) in der Nähe der anderen Mittellinie (M) der Karte gelegen sind.

11. Karte gemäß Anspruch 9, dadurch gekennzeichnet, daß die Achse (A) parallel zu einer kleinen Seite der Karte und der kleinen Mittellinie (M') ist und, daß die Kontakte (15) in der Nähe der großen Mittellinie (M) der Karte nahe einer ihrer Ränder gelegen sind.

12. Karte gemäß Anspruch 9, dadurch gekennzeichnet, daß die Achse (A) mit der großen Mittellinie (M) der Karte verschmolzen ist und, daß die Kontakte (15) in der Nähe einer der Enden der genannten Mittellinie sind.

**Claims**

1. A flexible printed circuit (10) provided with conductors (14) connected to contacts (15) distributed over a first zone of the circuit and intended for a connection made in a second zone of the circuit, remote from the first, said conductors (14) leaving the respective contacts (15) substantially perpendicular to the axis (A) of the printed circuit joining the two zones, characterised in that said conductors then form loops or meanderings relative to this axis, as far as the second zone.

2. A printed circuit according to Claim 1, characterised in that the contacts (15) are distributed over the first zone in two rows parallel to the axis (A) of the printed circuit.

3. A printed circuit according to Claim 1, characterised in that the contacts (15) are distributed in two rows parallel to each other and perpendicular to the axis (A) of the circuit, and in that the innermost contacts of the contact zone have their dimension parallel to said axis (A) larger than the corresponding dimension of the outermost contacts, such that each contact (15) is accessible by a section (14a) of conductor arriving at the first zone, perpendicular to the axis (A).

4. A printed circuit according to one of Claims 1 to 3, characterised in that the contacts (15) are distributed over the first zone uniformly on either side of the axis (A) of the printed circuit.

5. A printed circuit according to one of Claims 1 to 4, characterised in that the conductors arrive substantially perpendicular to the axis (A) of the printed circuit at regions (16) situated in said second zone.

6. A printed circuit according to Claim 5, characterised in that the regions (16) are distributed over the second zone uniformly on either side of the axis A of the printed circuit.

7. A printed circuit according to claims 5 or 6, characterised in that, in said second zone, it carries an integrated circuit (12) provided with terminals (18) each connected to one of the regions (16).

8. A printed circuit according to Claim 7, characterised in that the integrated circuit is placed in an aperture (17) made in said second zone.

9. An electronic microcircuit card (11), characterised in that it incorporates a printed circuit as defined by one of Claims 1 to 8.

10. A card according to Claim 9, characterised in that the axis (A) is parallel to one median line (M′) of the card and the contacts (15) are situated close to the other median line (M) of the card.

11. A card according to Claim 9, characterised in that the axis (A) is parallel to a short side of the card and the short median line (M′), and in that the contacts (15) are situated close to the long median line (M) of the card, near one of its ends.

12. A card according to Claim 9, characterised in that the axis (A) is merged with the long median line (M) of the card and in that the contacts (15) are close to one of the ends of said median line.

## FIG.1

## FIG.2

## FIG.3

## FIG.4

## FIG.5